# EUROPEAN PATENT SPECIFICATION

(11) **EP 1 951 786 B1**
(45) Date of publication and mention of the grant of the patent: **23.03.2011**
(21) Application number: 06806522.6
(22) Date of filing: 25.10.2006
(51) Int. Cl.: C08G 61/12, H01L 51/30

(54) **PROCESS OF PREPARING REGIOREGULAR POLYMERS**
VERFAHREN ZUR HERSTELLUNG VON REGIOREGULÄREN POLYMEREN
PROCEDE DE PREPARATION DE POLYMERES REGIOREGULIERS

(30) Priority: 24.11.2005 EP 05025622
(43) Date of publication of application: 06.08.2008
(73) Proprietor: Merck Patent GmbH, 64293 Darmstadt (DE)
(72) Inventor: HEENEY, Martin, Southampton SO14 6TQ (GB); ZHANG, Weimin, Southampton SO16 1QJ (GB); DUFFY, Warren, Southampton SO15 5EF (GB); MCCULLOCH, Iain, Southampton SO53 4LG (GB); KOLLER, Guntram, 64823 Gross-Umstadt (DE)
(86) International application number: PCT/EP2006/010267
(87) International publication number: WO 2007/059838

(56) References cited:
- EP-A2- 1 028 136
- WO-A-2006/084545
- WO-A2-2005/014691
- US-A- 4 521 589
- CHEN T-A ET AL: "REGIOCONTROLLED SYNTHESIS OF POLY(3-ALKYLTHIOPHENES) MEDIATED BY RIEKE ZINC: THEIR CHARACTERIZATION AND SOLID STATE PROPERTIES" JOURNAL OF THE AMERICAN CHEMICAL SOCIETY, AMERICAN CHEMICAL SOCIETY, WASHINGTON, DC, US, vol. 117, 1995, pages 233-244, XP002913786 ISSN: 0002-7863

## Description

### Field of Invention

The invention relates to a process of preparing regioregular polymers, in particular head-to-tail (HT) poly-(3-substituted) thiophenes with high regioregularity, and to novel polymers prepared by this process. The invention further relates to the use of the novel polymers as semiconductors or charge transport materials in optical, electrooptical or electronic devices including field effect transistors (FETs), electroluminescent, photovoltaic and sensor devices. The invention further relates to FETs and other semiconducting components or materials comprising the novel polymers.

### Background and Prior Art

Organic materials have recently shown promise as the active layer in organic based thin film transistors and organic field effect transistors (OFETs) (see Katz, Bao and Gilat, Acc. Chem. Res., 2001, 34, 5, 359). Such devices have potential applications in smart cards, security tags and the switching element in flat panel displays. Organic materials are envisaged to have substantial cost advantages over their silicon analogues if they can be deposited from solution, as this enables a fast, large-area fabrication route.

The performance of the device is principally based upon the charge carrier mobility of the semiconducting material and the current on/off ratio, so the ideal semiconductor should have a low conductivity in the off state, combined with a high charge carrier mobility (> 1 x 10⁻³ cm² V⁻¹ s⁻¹). In addition, it is important that the semiconducting material is relatively stable to oxidation i.e. it has a high ionisation potential, as oxidation leads to reduced device performance.

In prior art regioregular head-to-tail (HT) poly-(3-alkylthiophene) (P3AT), in particular poly-(3-hexylthiophene) (P3HT), has been suggested for.use as semiconducting material, as it shows charge carrier mobility between 1 x 10⁻⁵ and 0.1 cm² V⁻¹ s⁻¹. **P3AT** is a semi-conducting polymer that has shown good performance as the active hole transporting layer in field effect transistors (see Sirringhaus et al, Nature, 1999, 401, 685-688), and photovoltaic cells (see Coakley, McGehee et al., Chem. Mater., 2004, 16, 4533). The charge carrier mobility, and hence the performance of these applications, have been shown to be strongly dependent on the regiorepositioning (or regioregularity) of the alkyl sidechains of the polymer backbone. A high regioregularity means a high degree of head-to-tail (HT) couplings and a low amount of head-to-head (HH) couplings or tail-to-tail (TT) couplings as shown below:

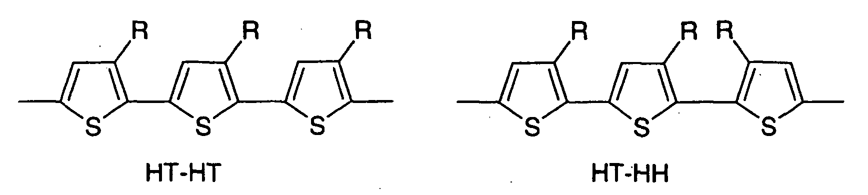

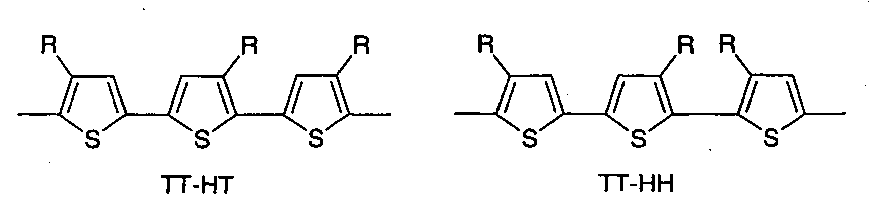

This leads to good packing of the polymers in the solid state and high charge carrier mobility.

Typically a regioregularity greater than 90% is necessary for good performance. In addition to high regioregularity, high molecular weights are desirable in order to enhance the processability and printability of formulations of P3AT. Higher molecular weights also result in increased glass transition temperatures for the polymer, whereas low glass transition temperatures can cause device failure during operation because of unwanted morphological changes occurring at raised temperatures.

Several methods to produce highly regioregular HT-P3AT have been reported in prior art, for example in the review of R.D. McCullough, Adv. Matter., 1998, 10(2), 93-116 and the references cited therein.

For example, regioregular polymers have been prepared by the "Stille-method" (see Stille, Iraqi, Barker et al., J. Mater. Chem., 1998, 8, 25) as illustrated below 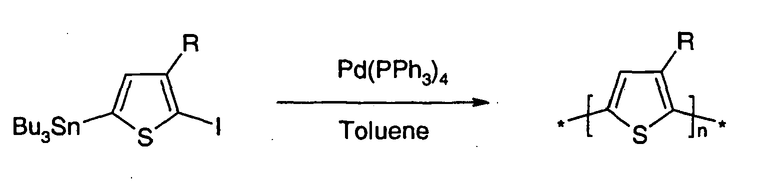 or by the "Suzuki=method" (see Suzuki, Guillerez, Bidan et al., Synth. Met., 1998, 93, 123) as shown below.

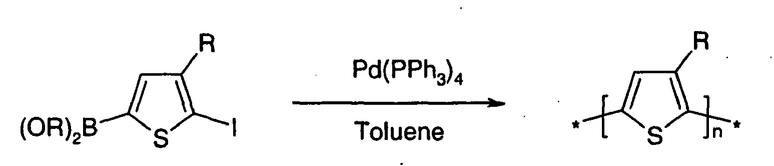

However, both of these methods have the drawback of requiring an additional process step to obtain and purify the organometallic intermediate.

Other known methods to prepare HT-P3AT with a regioregularity ≥ 90 %, starting from 2,5,dibromo-3-alkylthiophene, include for example the "Rieke method", wherein the educt (wherein R is alkyl) is reacted with highly reactive zinc in THF as illustrated below and disclosed e.g. in WO 93/15086 (A1).

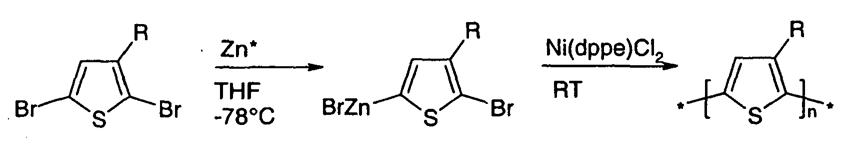

The resulting organozinc species is then reacted with a nickel (II) catalyst, (Ni(dppe)Cl₂, to afford the polymer. Reaction with a nickel (0) catalyst, Ni(PPh₃)₄, was reported to afford a polymer of lower regioregularity (65%). Reaction with a palladium (0) catalyst (Pd(PPh₃)₄) was also reported to afford a polymer of low regioregularity (50%) (see Chen, J. Am. Chem. Soc., 1992, 114, 10087).

Also known is the method to prepare regioregular HT-P3AT as described in McCullough et al., Adv. Mater., 1999,11(3), 250-253 and in EP 1 028 136 A1 and US 6, 166, 172. According to this route the educt is reacted with methylmagnesium bromide in THF as shown below.

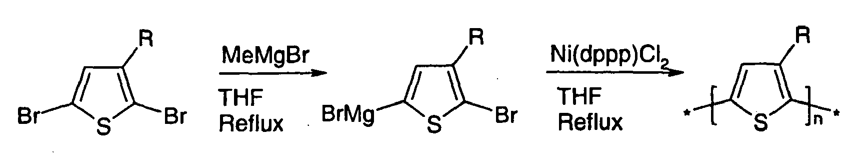

The resulting organomagnesium reagent is reacted with a nickel (II) catalyst to afford the regioregular polymer. In McCullough et al., Macromolecules, 2005, 38, 8649, this reaction is further investigated. This reference reports that the nickel (II) acts as an initiator in a 'living' type polymerization, that the molecular weight of the polymer is related to the concentration of nickel (II) catalyst, and that number average molecular weights (Mₙ) in the region of 10,000 with polydispersities around 1.5 are obtained.

Both the Rieke and McCullough methods specify the use of a nickel (II) catalyst in order to obtain polymer of high regioregularity. Molecular weights (Mₙ) in the region of 20-35,000 were reported.

However, for some applications, especially in FETs, P3ATs with molecular weights higher than those reported in prior art are desirable. High molecular weight polymers offer several advantages: As the molecular weight of a polymer increases, most properties scale with molecular weight until a plateau is reached, at which there is typically little further dependence. It is desirable to achieve molecular weights well above this plateau region in order to minimise a variation in performance with molecular weight, and hence minimise batch to batch discrepancies. Due to physical entanglements that occur in polymers of molecular weight above the plateau region, the mechanical properties improve. In addition, printing formulations of high molecular weight polymers can achieve high enough viscosity to be applied in a range of graphical arts printing processes including offset and gravure, whereas the typical viscosity achieved by regular P3HT of less than 1 Q centipoise would not suffice for such processes.

However, regioregular P3ATs with an Mₙ greater than 100,000 have not been previously reported in prior art.

Therefore, there is still a need for an improved method of preparing polymers, in particular P3ATs, with high regioregularity, high molecular weight, high purity and high yields in an economical, effective and environmentally beneficial way, which is especially suitable for industrial large scale production.

It was an aim of the present invention to provide an improved process for preparing polymers having these advantages, but not having the drawbacks of prior art methods mentioned above. Other aims of the present invention are immediately evident to the person skilled in the art from the following detailed description.

The inventors of the present invention have found that these aims can be achieved by providing a process according to the present invention as described below. Therein a suitable monomer, for example a 2,5,dibromo-3-alkylthiophene, is reacted with an appropriate Grignard reagent, for example methylmagnesium bromide, in the presence of a catalytic amount of a nickel (0) catalyst, for example bis(1,5-cyclooctadiene)nickel (0) [Ni(COD)₂], and a bidentate ligand, for example a phosphine ligand like diphenylphosphinopropane (dppp). It was surprisingly found that the use of a Ni(0) catalyst, rather than a Ni(II) catalyst, results in a highly reactive catalyst system affording polymers of very high molecular weights and high regioregularity. In comparative experiments utilising both Ni (0) and Ni (II) catalysts, improved molecular weights and regioregularities were found with a Ni (0) catalyst.

Prior art reports the polymerisation of 2,5-dibromo-3-alkylthiophene by adding a stoichiometric amount of bis(1,5-cyclooctadiene)nickel in the presence of a monodentate phosphine ligand as shown below (see Yamamoto, T. Macromolecules, 1992, 25, 1214).

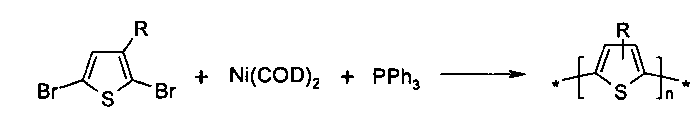

However, this method only afforded polymer of low regioregularity (65%) and intermediate molecular weight (Mₙ = 15,000). Besides, the use of stoichiometric amounts of Ni(COD)₂ is highly undesirable due to the toxicity of this reagent.

US 4,521,589 disclose a polythiophene that is substituted by lower alkyl in the 3-position. EP 1 028 136 A2, WO 2005/014691 A2, WO 2006/084545 A and Chen et al., JACS 117, 1995, pp.233-244 disclose methods for preparing regioregular poly(3-substituted) thiophenes. However, none of these documents discloses or suggests a process as claimed in the present application.

### Summary of the Invention

The invention relates to a process for preparing a regioregular polymer of formula I 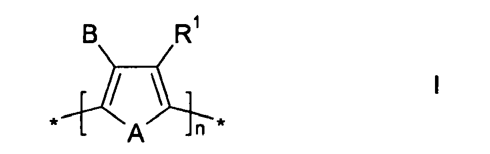 wherein A is S or Se, B is H or F, n is an integer > 1, and R¹ is selected from C₁-C₂₀-alkyl that is optionally substituted with one or more fluorine atoms, C₁-C₂₀-alkenyl, C₁-C₂₀-alkinyl, C₁-C₂₀-alkoxy, C₁-C₂₀-thioalkyl, C₁-C₂₀-silyl, C₁-C₂₀-amino or C₁-C₂₀-fluoroalkyl, in particular from alkenyl, alkinyl, alkoxy, thioalkyl or fluoroalkyl, all of which are straight-chain and have 1 to 12, preferably 5 to 12 C-atoms, most preferably pentyl, hexyl, heptyl, octyl, nonyl, decyl, undecyl or dodecyl
by reacting a monomer of formula II 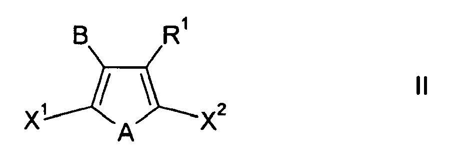 wherein A, B and R¹ are as defined in formula I, and X¹ and X² are independently of each other a suitable leaving group, with magnesium or reactive zinc or an organomagnesium halide, to form an organomagnesium or organozinc intermediate or a mixture of organomagnesium or organozinc intermediates, and
bringing the resulting intermediate(s) into contact with a catalytic amount of a Ni(0) catalyst and a bidentate ligand, and optionally agitating and/or heating the resulting mixture, to form a polymer.

The invention further relates to a process for preparing a regioregular polymer as described above and below, by
a1) reacting a compound of formula II with an organomagnesium halide in an organic solvent to generate an organomagnesium intermediate, or alternatively
a2) reacting a compound of formula II with magnesium metal in an organic solvent to generate an organomagnesium intermediate, or alternatively
a3) reacting a compound of formula II with reactive zinc in an organic solvent to generate an organozinc intermediate, or alternatively
a4) generating an organomagnesium intermediate as described in step a1) or a2), and reacting said intermediate with a zinc dihalide to generate an organozinc intermediate,
   and
b) adding a catalytic amount of a bidentate organic ligand and a catalytic amount of an organic Ni (0) compound or an organic Ni (0) complex to the intermediate, and optionally agitating and/or heating the resulting mixture, to form a polymer,
   and
c) optionally recovering the polymer from the mixture.

The poly-3-substituted thiophenes or selenophenes, obtainable or obtained by a process as described above and below, especially have a high molecular weight and a high regioregularity.

The polymers according to the invention can be used as charge-transport, semiconducting, electrically conducting, photoconducting or light-emitting material in optical, electrooptical or electronic components or devices, organic field effect transistors (OFET), integrated circuitry (IC), thin film transistors (TFT), flat panel displays, radio frequency identification (RFID) tags, electroluminescent or photoluminescent devices or components, organic light emitting diodes (OLED), backlights of displays, photovoltaic or sensor devices, charge injection layers, Schottky diodes, planarising layers, antistatic films, conducting substrates or patterns, electrode materials in batteries, photoconductors, electrophotographic applications, electrophotographic recording, organic memory devices, alignment layers, or for detecting and discriminating DNA sequences.

### Brief Description of the Drawings

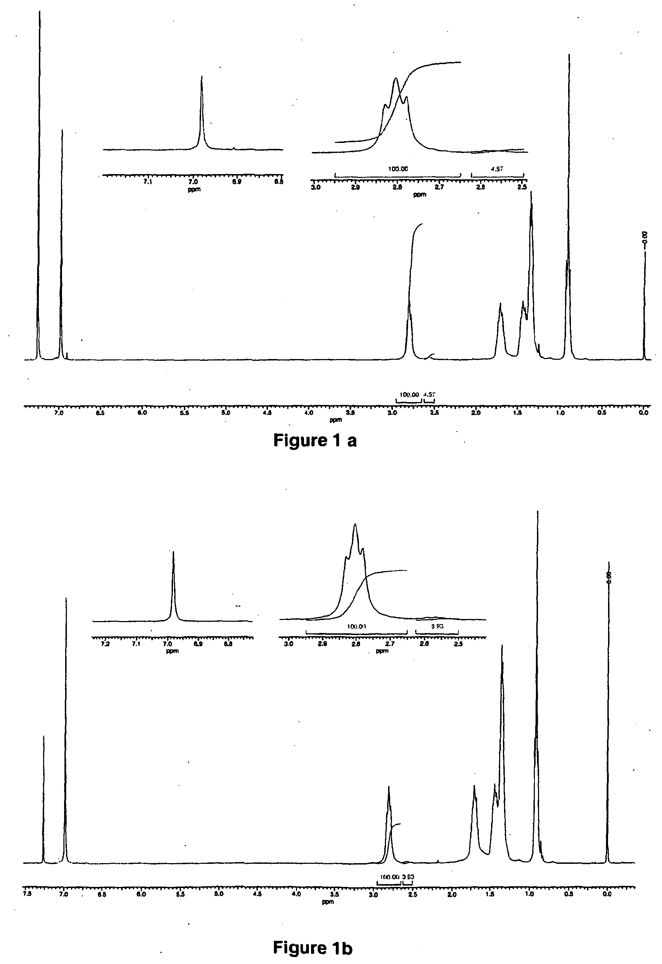

Figures 1a and 1b show the ¹H-NMR spectrum of poly(3-hexyl)thiophenes prepared according to example 2.

### Detailed Description of the Invention

The term "regioregular" means a polymer with a regioregularity of at least 85 %. "Regioregularity" means the number of head-to-tail couplings of monomer units in the polymer, divided by the number of total couplings, and expressed as a percentage. Especially preferred are polymers with a regioregularity of 90% or higher, very preferably 95% or higher, more preferably from 96% to 100%, most preferably from 98% to 100%.

The term "catalytic amount" means an amount that is clearly below one equivalent of the monomer that is reacted in the process according to the present invention, and preferably means an amount from > 0 to 0.5, very preferably from > 0 to 0.1, most preferably from > 0 to 0.05 equivalents of the monomer.

Unless stated otherwise, the molecular weight is given as the number average molecular weight Mₙ determined by gel permeation chromatography (GPC) against polystyrene standards. The degree of polymerization (n) means the number average degree of polymerization, given as n = Mₙ/M_{U}, wherein M_{U} is the molecular weight of the single repeating unit (usually without considering the end groups of the polymer which are not part of the repeating unit, like groups X²¹ and X²² in formula I1).

The term "carbyl group" as used above and below denotes any monovalent or multivalent organic radical moiety which comprises at least one carbon atom either without any non-carbon atoms (like for example -C≡C-), or optionally combined with at least one non-carbon atom such as N, O, S, P, Si, Se, As, Te or Ge (for example carbonyl etc.). The terms "hydrocarbon group", and "hydrocarbyl group" denote a carbyl group that does additionally contain one or more H atoms and optionally contains one or more hetero atoms like for example N, O, S, P, Si, Se, As, Te or Ge.

A carbyl or hydrocarbyl group comprising a chain of 3 or more C atoms may also be linear, branched and/or cyclic, including spiro and/or fused rings.

Preferred carbyl and hydrocarbyl groups include alkyl, alkoxy, alkylcarbonyl, alkoxycarbonyl, alkylcarbonyloxy and alkoxycarbonyloxy, each of which is optionally substituted and has 1 to 40, preferably 1 to 25, very preferably 1 to 18 C atoms, furthermore optionally substituted aryl or aryloxy having 6 to 40, preferably 6 to 25 C atoms, furthermore alkylaryloxy, arylcarbonyl, aryloxycarbonyl, arylcarbonyloxy and aryloxycarbonyloxy, each of which is optionally substituted and has 6 to 40, preferably 7 to 40 C atoms.

The carbyl or hydrocarbyl group may be a saturated or unsaturated acyclic group, or a saturated or unsaturated cyclic group. Unsaturated acyclic or cyclic groups are preferred, especially aryl, alkenyl and alkinyl groups (especially ethinyl). Where the C₁-C₄₀ carbyl or hydrocarbyl group is acyclic, the group may be linear or branched. The C₁-C₄₀ carbyl or hydrocarbyl group includes for example: a C₁-C₄₀ alkyl group, a C₂-C₄₀ alkenyl group, a C₂-C₄₀ alkinyl group, a C₃-C₄₀ allyl group, a C₄-C₄₀ alkyldienyl group, a C₄-C₄₀ polyenyl group, a C₆-C₁₈ aryl group, a C₆-C₄₀ alkylaryl group, a C₆-C₄₀ arylalkyl group, a C₄-C₄₀ cycloalkyl group, a C₄-C₄₀ cycloalkenyl group, and the like. Preferred among the foregoing groups are a C₁-C₂₀ alkyl group, a C₂-C₂₀ alkenyl group, a C₂-C₂₀ alkinyl group, a C₃-C₂₀ allyl group, a C₄-C₂₀ alkyldienyl group, a C₆-C₁₂ aryl group and a C₄-C₂₀ polyenyl group, respectively. Also included are combnonations of groups having carbon atoms and groups having hetero atoms, like e.g. an alkinyl group, preferably ethinyl, that is substituted with a silyl group, preferably a trialkylsilyl group.

X¹ and X² in formula II are independently of each other a suitable leaving group, preferably halogen, very preferably Br, Cl or I, most preferably Br. Preferably X¹ and X² are identical.

If R¹ is an alkyl or alkoxy radical, i.e. where the terminal CH₂ group is replaced by -O-, this may be straight-chain or branched. It is preferably straight-chain, has 2 to 8 carbon atoms and accordingly is preferably ethyl, propyl, butyl, pentyl, hexyl, heptyl, octyl, ethoxy, propoxy, butoxy, pentoxy, hexyloxy, heptoxy, or octoxy, furthermore methyl, nonyl, decyl, undecyl, dodecyl, tridecyl, tetradecyl, pentadecyl, nonoxy, decoxy, undecoxy, dodecoxy, tridecoxy or tetradecoxy, for example. Especially preferred are n-hexyl and n-dodecyl.

If R¹ is an alkyl group wherein one or more CH₂ groups are replaced by - CH=CH-, this may be straight-chain or branched. It is preferably straight-chain, has 2 to 12 C-atoms and accordingly is preferably vinyl, prop-1-, or prop-2-enyl, but-1-, 2- or but-3-enyl, pent-1-, 2-, 3- or pent-4-enyl, hex-1-, 2-, 3-, 4- or hex-5-enyl, hept-1-, 2-, 3-, 4-, 5- or hept-6-enyl, oct-1-, 2-, 3-, 4-, 5-, 6- or oct-7-enyl, non-1-, 2-, 3-, 4-, 5-, 6-, 7- or non-8-enyl, dec-1-, 2-3-, 4-, 5-, 6-, 7-, 8- or dec-9-enyl, undec-1-, 2-, 3-, 4-, 5-, 6-, 7-, 8-, 9- or undec-10-enyl, dodec-1-, 2-, 3-, 4-, 5-, 6-, 7-, 8-, -9, -10 or undec-11-enyl. The alkenyl group may comprise C=C-bonds with E- or Z-configuration or a mixture thereof.

If R¹ is thioalkyl, i.e where one CH₂ group is replaced by -S-, is preferably straight-chain thiomethyl (-SCH₃), 1-thioethyl (-SCH₂CH₃), 1-thiopropyl (= -SCH₂CH₂CH₃), 1- (thiobutyl), 1-(thiopentyl), 1-(thiohexyl), 1-(thioheptyl), 1-(thiooctyl), 1-(thiononyl), 1-(thiodecyl), 1-(thioundecyl) or 1-(thiododecyl), wherein preferably the CH₂ group adjacent to the sp² hybridised vinyl carbon atom is replaced.

If R¹ is fluoroalkyl, it is preferably straight-chain perfluoroalkyl CᵢF₂₊ᵢ, wherein i is an integer from 1 to 15, in particular CF₃, C₂F₅, C₃F₇, C₄F₉, C₅F₁₁, C₆F₁₃, C₇F₁₅ or C₈F₁₇, very preferably C₆F₁₃.

-CY¹=CY²- is preferably -CH=CH-, -CF=CF- or -CH=C(CN)-.

Aryl and heteroaryl preferably denote a mono-, bi- or tricyclic aromatic or heteroaromatic group with up to 25 C atoms that may also comprise condensed rings and is optionally substituted with one or more groups L, wherein L is halogen or an alkyl, alkoxy, alkylcarbonyl or alkoxycarbonyl group with 1 to 12 C atoms, wherein one or more H atoms may be replaced by F or Cl.

Especially preferred aryl and heteroaryl groups are phenyl in which, in addition, one or more CH groups may be replaced by N, naphthalene, thiophene, thienothiophene, dithienothiophene, alkyl fluorene and oxazole, all of which can be unsubstituted, mono- or polysubstituted with L as defined above.

In the first step (step a) of the process according to the present invention, a 3-substituted thiophene or selenophene of formula II (hereinafter also referred to as the 'educt') is reacted with an organic magnesium halide or with magnesium or with reactive zinc.

In a first preferred embodiment, the monomer of formula II is reacted with an organomagnesium halide (step a1). The organomagnesium halide is preferably selected of formula III

R²-Mg-X¹ III

wherein
- R²: is straight chain, branched or cyclic alkyl with 1 to 20 C-atoms, which is unsubstituted or mono- or polysubstituted by F, Cl, Br or I, and wherein one or more non-adjacent CH₂ groups are optionally replaced, in each case independently from one another, by -O-, -S-, -NR⁰-, -SiR⁰R⁰⁰-, -CY¹=CY²- or -C≡C- in such a manner that O and/or S atoms are not linked directly to one another, or aryl or heteroaryl which is optionally substituted by one or more groups L,
- L: is F, Cl, Br, I or alkyl, alkoxy or thioalkyl with 1 to 20 C atoms, wherein one or more H atoms may be substituted by F or Cl,
- R⁰ and R⁰⁰: are independently of each other H or alkyl with 1 to 12 C-atoms,
- Y¹ and Y²: are independently of each other H, F or Cl,
and X¹ is halogen as defined in formula II.

If R² is an alkyl group it may be straight-chain or branched. It is preferably straight-chain, has 2, 3, 4, 5, 6, 7 or 8 carbon atoms and accordingly is preferably methyl, ethyl, propyl, butyl, pentyl, hexyl, heptyl, octyl, nonyl, decyl, undecyl, dodecyl, tridecyl, tetradecyl, or pentadecyl, for example.

If R² is an alkyl group wherein one or more CH₂ groups are replaced by - CH=CH-, this may be straight-chain or branched. It is preferably straight-chain, has 2 to 10 C-atoms and accordingly is preferably vinyl, prop-1-, or prop-2-enyl, but-1-, 2- or but-3-enyl, pent-1-, 2-, 3- or pent-4-enyl, hex-1-, 2-, 3-, 4- or hex-5-enyl, hept-1-, 2-, 3-, 4-, 5- or hept-6-enyl, oct-1-, 2-, 3-, 4-, 5-, 6- or oct-7-enyl, non-1-, 2-, 3-, 4-, 5-, 6-, 7- or non-8-enyl, dec-1-, 2-3-, 4-, 5-, 6-, 7-, 8- or dec-9-enyl.

R² can also be a chiral group like for example 2-butyl (=1-methylpropyl), 2-methylbutyl, 2-methylpentyl, 3-methylpentyl, 2-ethylhexyl, 2-propylpentyl, 4-methylhexyl, 2-hexyl, 2-octyl, 2-nonyl, 2-decyl, 2-dodecyl, 1,1,1-trifluoro-2-octyl, 1,1,1-trifluoro-2-hexyl or an achiral branched group like for example isopropyl, isobutyl (=methylpropyl) or isopentyl (=3-methylbutyl).

If R² is aryl or heteroaryl it is preferably selected from phenyl, benzyl, fluorinated phenyl, pyridine, pyrimidine, biphenyl, naphthalene, thiophene, selenophene, fluorinated thiophene, benzo[1,2-b:4,5-b']dithiophene, thiazole and oxazole, all of which are unsubstituted, mono- or polysubstituted with L as defined above.

Very preferably R² is straight-chain or branched alkyl or alkenyl with 1 to 12 C atoms, phenyl or benzyl, in particular vinyl, butyl, propyl or isopropyl.

Preferably the educt is dissolved in a solvent, and the organomagnesium halide is added to the solution, very preferably under an inert gas atmosphere, preferably at a temperature between 0°C and 25°C. Alternatively the organomagnesium halide is dissolved and the educt added to the solution. The compound to be added to the solution can itself also be dissolved in the solvent, and the two solutions then be combined. The organomagnesium halide is preferably added in a ratio of 0.9 to 1.05 equivalents with respect to the educt, most preferably between 0.95 and 0.98.

Suitable and preferred solvents are selected from cyclic or linear organic ethers. Preferred solvents include, without limitation, THF, 2-methyltetrahydrofuran, diethyl ether, tetrahydropyran and dioxane. It is also possible to use a mixture of two or more solvents.

The addition of the reactants is preferably carried out in the absence of oxygen and water, for example under an inert gas atmosphere like nitrogen or argon. The temperature can be any temperature between 0ºC and solvent reflux. Preferably the reactants are added to each other at 0ºC or RT.

The educt reacts with the organomagnesium halide to form a Grignard intermediate product. The reaction conditions (solvent, temperature, atmosphere) are as described above. Typically the reaction mixture is stirred for a given period of time, for example 5 minutes to 1 hour, at a temperature between 0°C and 25°C and then heated at reflux for a given period of time, for example from 10 minutes to 2 hours. Other reaction times or conditions can be selected by the skilled person based on general knowledge.

The compounds of formula II and III react into a Grignard intermediate product, which is usually a mixture of regiochemical isomers of formula IVa and IVb and may also include a, typically small, amount of the double-Grignard product of formula IVc 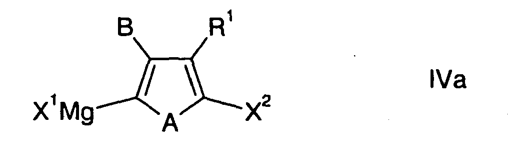 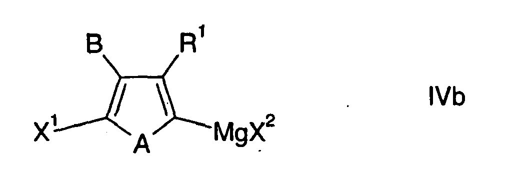 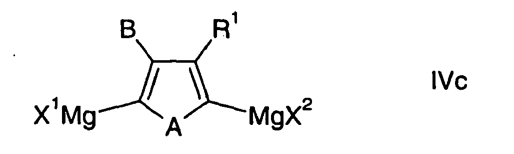 wherein A, B, X¹, X² and R¹ have the meanings of formula II.

The ratio of the intermediates is depending on the reaction conditions, for example the ratio of educts of formula II and III, the solvent, temperature and reaction time. Under the reaction conditions as described above, the ratio of intermediates of formula IVa and IVb is usually 90% or higher, more typically 95% or higher. The ratio is IVa to IVb is typically between 3:1 to 5:1.

A second preferred embodiment relates to a process wherein in the first step (step a2) the organomagnesium intermediate, or the mixture of intermediates of formula IVa-c, is generated by using pure magnesium instead of an organomagnesium halide, in analogy to the process described in WO 2005/014691 A2. For example the reaction of a 2,5-dibromo-3-alkylthiophene with magnesium metal in an organic solvent under the conditions described in WO 2005/014691 A2 yields a thiophene organomagnesium intermediate, or a mixture of intermediates, which are polymerised in a second step in the presence of a Ni(0) catalyst as described above and below.

A third preferred embodiment relates to a process wherein in the first step (step a3), instead of an organomagnesium intermediate, an organozinc intermediate, or a mixture of organozinc intermediates, are generated by reacting the educt of formula II with reactive zinc, for example 'Rieke zinc', in analogy to the process described for example in WO 93/15086 A1.

A fourth preferred embodiment relates to a process wherein in the first step (step a4), an organomagnesium intermediate or a mixture of organomagnesium intermediates is prepared as described in step a1) or step a2), and then an organozinc intermediate or a mixture of organozinc intermediates is prepared by transmetallation of the organomagnesium intermediate(s) with a zinc dihalide, like e.g. ZnCl₂. This can be achieved by methods that are known to the person skilled in the art and are described in the literature (see for example E. Nakamura in Organometallics in Synthesis. A Manual, M. Schlosser (Ed.), Chichester, Wiley, 2002).

In a second step (step b) of the process according to the present invention, the organomagnesium intermediate or organozinc intermediate, or the mixture of intermediates, is brought into contact with a catalytic amount of a Ni(0) compound and a bidentate ligand. In this connection, "bring into contact" means for example that the Ni(0) catalyst and the ligand are added to a solution containing the intermediate(s) under conditions as described above. Alternatively the catalyst and ligand are dissolved in a solvent and the intermediate(s), or a solution thereof, are added, or the solution of catalyst and ligand is added to the intermediate or solution thereof.

Preferably the catalyst and the ligand are directly added to reaction mixture of the first step described above containing the intermediate(s), under conditions as described above, very preferably at a temperature from 0ºC to reflux, most preferably at reflux.

Addition of the catalyst is preferably carried out as a two-step addition: First the bidentate ligand is added, followed by the Ni(0) catalyst. Alternatively, the ligand and the Ni (0) catalyst are predissolved in a dry solvent, for example a solvent as listed above, and then added to the reaction mixture as a solution.

The organic bidentate ligand is preferably a phosphine ligand. Principally any bidentate phosphine ligand known to the skilled person can be used. Suitable and preferred phosphine ligands include, without limitation, 1,2-bis(diphenylphosphino)ethane (dppe), 1,3-bis(diphenylphosphino)propane (dppp), 1,4-bis(diphenylphosphino)butane (dppb), 1,1'-bis(diphenylphosphino)ferrocene (dppf), 2,2'-bis(diphenylphosphino)-1,1'-binaphthyl (BINAP), and 1,2-bis(dicylohexylphosphino)ethane.

As nickel catalyst principally any Nickel (0) catalyst known to the skilled person can be used. Suitable and preferred catalysts include, without limitation, organic Ni (0) compounds or complexes like Ni(COD)₂ or nickel (0) tetracarbonyl [Ni(CO)₄].

The ratio of ligand to Ni (0) catalyst is preferably from 10:1 to 0.1:1, very preferably from 5:1 to 1:1, most preferably 2.2:1.

The catalyst is preferably added such that the amount of Ni (0) is from 0.1 to 10 %, very preferably 0.5 to 1 mol % of the thiophene educt.

The catalyst system then initiates the polymerization reaction. The reaction is preferably carried out under conditions as described above, including stirring or otherwise agitating the reaction mixture, applying an inert gas atmosphere, keeping the temperature typically from 0°C to reflux, preferably at reflux, for a time from several minutes to several hours or days, typically from 20 to 40 hours.

The process according to the present invention is characterized by adding a Ni(0) catalyst, instead of a NI(II) catalyst as used in the methods disclosed in prior art. The use of Ni(0) instead of Ni(II) avoids a pre-reduction step in the reaction mechanism. Thus, in the methods according to prior art the Ni(II) is only active once it has been reduced in situ to a Ni(0) catalyst, which occurs by the oxidative coupling of two thiophene organomagnesium intermediates to afford an undesired tail-to-tail (TT) isomer, as illustrated in Scheme 1 below.

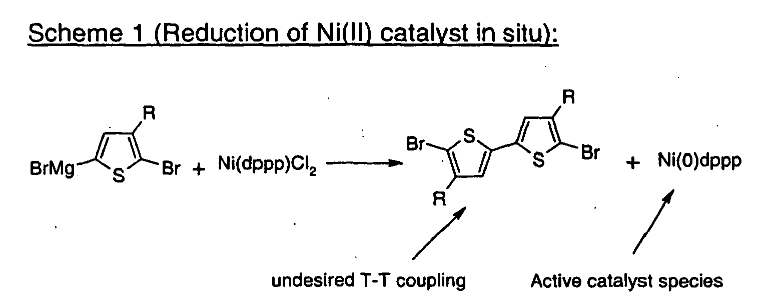

In contrast, in the process according to the present invention a Ni(0) catalyst is used, so that a pre-reduction step to generate the active catalyst is not necessary, and an undesired TT coupling is avoided.

The reaction then proceeds by the oxidative addition of the Ni(0) catalyst to the thiophene (selenophene) bromide bond. Subsequent nucleophillic displacement of the bromide by a thiophene (selenophene) organomagnesium reagent, and reductive elimination of the Ni(0) generates the thiophene-thiophene (selenophene-selenophene) bond and regenerates the active Ni(0) catalyst.

In the next step (step c) the polymer is typically isolated from the reaction mixture and purified according to standard procecures known to skilled person.

In the process according to the present invention, a high percentage of intermediates of formula IVa, or the corresponding organozinc intermediates, will lead to a high amount of HT-couplings in the polymer as illustrated by formula la 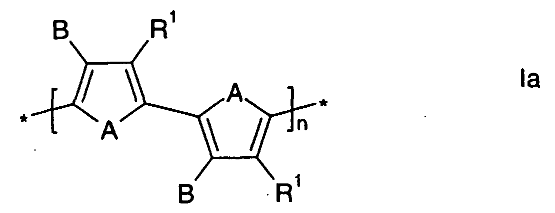 wherein A, B, R¹ and n have the meanings given above.

The regioregularity in the polymers according to the present invention is preferably at least 85 %, in particular 90% or higher, very preferably 95% or higher, most preferably from 96 to 100%.

The polymers according to the present invention preferably have a degree of polymerisation (number n of recurring units) from 2 to 5,000, in particular from 10 to 5,000, very preferably from 50 to 1,500, most preferably from above 100 to 1,000. Further preferred are polymers wherein n ≥ 150. Further preferred are polymers wherein n ≥ 200. Further preferred are polymers wherein n ≥ 400. Further preferred are polymers wherein n ≤ 5,000. Further preferred are polymers wherein n ≤ 3,000. Further preferred are polymers wherein n ≤ 1,500.

The polymers according to the present invention preferably a number average molecular weight Mₙ from 5,000 to 300,000, in particular higher than 25,000, very preferably higher than 50,000, most preferably higher than 75,000. Further preferred are polymers having a molecular weight Man from 50,000 to 300,000, very preferably from 100,000 to 250,000. Mₙ is defined as the number average molecular weight and is typically determined by gel permeation chromatography against polystyrene standards.

In another preferred embodiment of the present invention, the terminal groups of the polymer are chemically modified ('endcapped') during or after polymerisation. Endcapping can be carried out before or after recovering the polymer from the polymerisation reaction mixture, before or after work-up of the polymer or before or after its purification, depending on which is more suitable and more effective regarding the material costs, time and reaction conditions involved. For example, in case expensive co-reactants are used for endcapping it may be more economical to carry out the endcapping after purification of the polymer. In case the purification effort is economically more important than the co-reactants it may be preferred to carry out the endcapping before purification or even before recovering the polymer from the polymerisation reaction mixture.

Suitable endcapping methods are known to the skilled person and are described for example in US 6,602,974, WO 2005/014691 or EP 05002918.0. Furthermore, endcapping can be carried out as described below:

As a result of the process according to the present invention, at the end of the polymerisation step the end groups (X¹ and X²) are either a halogen or a Grignard group. Also, small amounts of endgroups R² can be present as a result of a reaction with the byproduct R²X² from the preparation of the thiophene intermediate. For endcapping, typically an aliphatic Grignard reagent RMgX or dialkyl Grignard reagent MgR₂, wherein X is halogen and R is an aliphatic group, or active magnesium is added to convert the remaining halogen end groups to Grignard groups. Subsequently, for example to give an alkyl end group an excess of an ω-haloalkane is added which will couple to the Grignard. Alternatively, to give a proton end group the polymerisation is quenched into a non-solvent such as an alcohol.

To provide reactive functional end groups, like for example hydroxyl or amine groups or protected versions thereof, the halogen end groups are for example reacted with a Grignard reagent R'MgX, wherein R' is such a reactive functional group or protected reactive functional group.

Instead of a Grignard reagent it is also possible to carry out endcapping using an organo lithium reagent, followed by addition of an ω-haloalkane.

It is also possible to replace H end groups by reactive functional groups by using e.g. the methods described in US 6,602,974, such as a Vilsmeier reaction to introduce aldehyde groups followed by reduction with metal hydrides to form hydroxyl groups.

If the polymer has been fully worked up prior to endcapping, it is preferred to dissolve the polymer in a good solvent for Grignard coupling such as diethyl ether or THF. The solution is then treated for example with the above mentioned organo Grignard reagent RMgX or MgR₂ or R'MgX or with a zinc reagent, RZnX, R'ZnX or ZnR₂, where R and R' are as defined above. A suitable nickel or palladium catalyst is then added along with the haloalkane.

Very preferred are endcapped polymers wherein the terminal groups during or after polymerisation are replaced by H or an alkyl group (hereinafter also referred to as 'polymers endcapped by H or an alkyl group').

Preferably endcapping is carried out before purification of the polymer. Further preferably endcapping is carried out after step d) of the process as described above and below. In another preferred embodiment of the present invention the endcapper is added during polymerisation to remove the end groups and possibly control the molecular weight of the polymer.

Preferably, substantially all molecules in a polymer sample are endcapped in accordance with this invention, but at least 80 %, preferably at least 90 %, most preferably at least 98 % are endcapped.

By chemical modification of the terminal groups (endcapping) of the polymers according to the present invention, it is possible to prepare novel polymers with different terminal groups. These polymers are preferably selected of formula I1 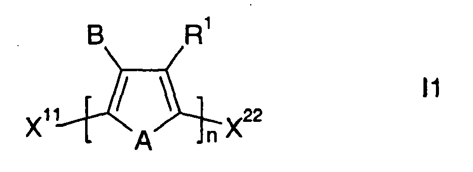 wherein A, B, n and R¹ have the meanings given in formula I and II, and X¹¹ and X²² are independently of each other H, halogen, stannate, boronate or an aliphatic, cycloaliphatic or aromatic group that may also comprise one or more hetero atoms.

Especially preferably X¹¹ and X²² are selected from H or straight-chain or branched alkyl with 1 to 20, preferably 1 to 12, very preferably 1 to 6 C-atoms, most preferably straight-chain alkyl or branched alkyl like isopropyl or tert. butyl. Aromatic groups X¹¹ and X²² tend to be bulky and are less preferred.

As described above, the end groups X¹¹ and X²² are preferably introduced by reacting the polymer of formula I1 with a Grignard reagent MgRX, MgR₂ or MgR'X as described above, wherein R and R' are X¹¹ or X²² as defined in formula I2.

By introducing suitable functional end groups X¹¹ and/or X²² it is possible to prepare block copolymers from the polymers according to the present invention. For example, if one or both of the end groups X¹¹ and X²² in a polymer of formula I2 is a reactive group or a protected reactive group, like for example an optionally protected hydroxy or amine group, they can be reacted (after removing the protective group) with the end group of another polymer of formula I2 (e.g. with different groups R¹ and/or X¹¹ and/or X²²), or with a polymer of different structure. If one of X¹¹ and X²² is a reactive group, diblock copolymers can be formed. If both X¹¹ and X²² are reactive groups, a triblock copolymer can be formed.

Alternatively a block copolymer can be formed by introducing reactive or protected reactive groups X¹¹ and/or X²², adding a catalyst and one or monomers, and initiating a new polymerization reaction starting from the site of the groups X¹¹ and/or X²².

Suitable functional end groups and methods of their introduction can be taken from the above disclosure and from prior art. Details how to prepare block copolymers can also be taken e.g. from US 6,602,974.

The polymers of the present invention are useful as optical, electronic and semiconductor materials, in particular as charge transport materials in field effect transistors (FETs), e.g., as components of integrated circuitry, ID tags or TFT applications. Alternatively, they may be used in organic light emitting diodes (OLEDs) in electroluminescent display applications or as backlight of, e.g., liquid crystal displays, as photovoltaics or sensor materials, for electrophotographic recording, and for other semiconductor applications.

The polymers according to the present invention show especially advantageous solubility properties which allow production processes using solutions of these compounds. Thus films, including layers and coatings, may be generated by low cost production techniques, e.g., spin coating. Suitable solvents or solvent mixtures comprise alkanes and/ or aromatics, especially their fluorinated or chlorinated derivatives.

A solution or formulation comprising one or more polymers and one or more solvents is another aspect of the invention. The formulation can additionally comprise one or more other suitable components or additives selected for example from catalysts, sensitizers, stabilizers, inhibitors, chain-transfer agents, co-reacting monomers, surface-active compounds, lubricating agents, wetting agents, dispersing agents, hydrophobing agents, adhesive agents, flow improvers, defoaming agents, deaerators, diluents, reactive diluents, auxiliaries, colourants, dyes, pigments or nanoparticles.

The polymers of the present invention are especially useful as charge transport materials in FETs. Such FETs, where an organic semiconductive material is arranged as a film between a gate-dielectric and a drain and a source electrode, are generally known, e.g., from US 5,892,244, WO 00/79617, US 5,998,804, and from the references cited in the background and prior art chapter and listed below. Due to the advantages, like low cost production using the solubility properties of the compounds according to the invention and thus the processibility of large surfaces, preferred applications of these FETs are such as integrated circuitry, TFT-displays and security applications.

In security applications, field effect transistors and other devices with semiconductive materials, like transistors or diodes, may be used for ID tags or security markings to authenticate and prevent counterfeiting of documents of value like banknotes, credit cards or ID cards, national ID documents, licenses or any product with money value, like stamps, tickets, shares, cheques etc..

Alternatively, the polymers according to the invention may be used in organic light emitting devices or diodes (OLEDs), e.g., in display applications or as backlight of e.g. liquid crystal displays. Common OLEDs are realized using multilayer structures. An emission layer is generally sandwiched between one or more electron-transport and/ or hole-transport layers. By applying an electric voltage electrons and holes as charge carriers move towards the emission layer where their recombination leads to the excitation and hence luminescence of the lumophor units contained in the emission layer. The inventive compounds, materials and films may be employed in one or more of the charge transport layers and/ or in the emission layer, corresponding to their electrical and/ or optical properties. Furthermore their use within the emission layer is especially advantageous, if the polymers according to the invention show electroluminescent properties themselves or comprise electroluminescent groups or compounds. The selection, characterization as well as the processing of suitable monomeric, oligomeric and polymeric compounds or materials for the use in OLEDs is generally known by a person skilled in the art, see, e.g., Meerholz, Synthetic Materials, 111-112, 2000, 31-34, Alcala, J. Appl. Phys., 88, 2000, 7124-7128 and the literature cited therein.

According to another use, the polymers according to the present invention, especially those which show photoluminescent properties, may be employed as materials of light sources, e.g., of display devices such as described in EP 0 889 350 A1 or by C. Weder et al., Science, 279, 1998, 835-837.

A further aspect of the invention relates to both the oxidised and reduced form of the polymers according to this invention. Either loss or gain of electrons results in formation of a highly delocalised ionic form, which is of high conductivity. This can occur on exposure to common dopants. Suitable dopants and methods of doping are known to those skilled in the art, e.g., from EP 0 528 662, US 5,198,153 or WO 96/21659.

The doping process typically implies treatment of the semiconductor material with an oxidating or reducing agent in a redox reaction to form delocalised ionic centres in the material, with the corresponding counterions derived from the applied dopants. Suitable doping methods comprise for example exposure to a doping vapor in the atmospheric pressure or at a reduced pressure, electrochemical doping in a solution containing a dopant, bringing a dopant into contact with the semiconductor material to be thermally diffused, and ion-implantantion of the dopant into the semiconductor material.

When electrons are used as carriers, suitable dopants are for example halogens (e.g., I₂, Cl₂, Br₂, ICl, ICl₃, IBr and IF), Lewis acids (e.g., PF₅, AsF₅, SbF₅, BF₃, BCl₃, SbCl₅, BBr₃ and SO₃), protonic acids, organic acids, or amino acids (e.g., HF, HCl, HNO₃, H₂SO₄, HClO₄, FSO₃H and ClSO₃H), transition metal compounds (e.g., FeCl₃, FeOCl, Fe(ClO₄)₃, Fe(4-CH₃C₆H₄SO₃)₃, TiCl₄, ZrCl₄, HfCl₄, NbF₅, NbCl₅, TaCl₅, MoF₅, MoCl₅, WF₅, WCl₆, UF₆ and LnCl₃ (wherein Ln is a lanthanoid), anions (e.g., Cl⁻, Br⁻, I⁻, I₃⁻, HSO₄⁻, SO₄²⁻, NO₃⁻, ClO₄⁻, BF₄⁻_{,} PF₆⁻, AsF₆⁻, SbF₆⁻, FeCl₄⁻, Fe(CN)₆³⁻, and anions of various sulfonic acids, such as aryl-SO₃⁻). When holes are used as carriers, examples of dopants are cations (e.g., H⁺, Li⁺, Na⁺, K⁺, Rb⁺ and Cs⁺), alkali metals (e.g., Li, Na, K, Rb, and Cs), alkaline-earth metals (e.g., Ca, Sr, and Ba), O₂, XeOF₄, (NO₂⁺) (SbF₆⁻), (NO₂⁺) (SbCl₆⁻), (NO₂⁺) (BF₄⁻), AgClO₄, H₂IrCl₆, La(NO₃)₃ · 6H₂O, FSO₂OOSO₂F, Eu, acetylcholine, R₄N⁺, (R is an alkyl group), R₄P⁺ (R is an alkyl group), R₆As⁺ (R is an alkyl group), and R₃S⁺ (R is an alkyl group).

The conducting form of the polymers of the present invention can be used as an organic "metal" in applications, for example, but not limited to, charge injection layers and ITO planarising layers in organic light emitting diode applications, films for flat panel displays and touch screens, antistatic films, printed conductive substrates, patterns or tracts in electronic applications such as printed circuit boards and condensers.

The examples below shall illustrate the invention without limiting it.

### Example 1: Regioregular poly(3-hexyl)thiophene

Butylmagnesium chloride (10.3 ml of a 1.8M solution in THF, 18.7 mmol) is added to a solution of 2,5-dibromo-3-hexylthiophene (6.33 g, 19.3 mmol) in anhydrous THF (60 ml) at 18-20°C, under N₂. This mixture is stirred for 25 min at 18-20ºC, then heated at reflux for 1 hour. Reflux is stopped, and 1,2-bis(diphenylphosphino)ethane (0.137 g, 0.33 mmol) then bis(1,5-cyclooctadiene)nickel (0) (39 mg, 0.14 mmol) are added and the resultant mixture is refluxed for 30 h. The reaction mixture is cooled to 18-20ºC, then poured into methanol. The precipitate is filtered and washed with acetone, then dissolved in hot chlorobenzene. This solution is added dropwise to methanol, to form a purple precipitate, which is futher purified by washing with heptane (soxhlet) for 30 h. The product is dried in a vacuum oven, to give the polymer as a purple solid (2.51 g, 77%). GPC (C₆H₅Cl, 60ºC, RI) Mₙ 121,000, M_{w} 447,000. ¹H NMR (CDCl₃, 300 MHz) δ 6.98 (s, 1H). 2.81 (t, 2H), 1.71 (m, 2H), 1.5-1.3 (m, 6H), 0.91 (t, 3H). Regioregularity is 96%.

### Example 2 - Comparison Experiment

Two identical solutions of thiophene organomagnesium reagent are prepared as follows:

A solution of n-Butylmagnesium chloride (7.4 ml of a 1.8M solution in THF, 13.5 mmol) is added to a solution of 2,5-dibromo-3-hexylthiophene (4.65 g, 14.2 mmol) in THF (45 ml). The solution is stirred for 20 min, and then heated to reflux for 1 h. Reflux is stopped and either [1,2-bis(diphenyl-phosphino)ethane]dichloronickel (II) (53 mg, 0.098 mmol) or 1,2-bis(diphenylphosphino)ethane (86 mg, 0.21 mmol) followed by Ni(COD)2 (25 mg, 0.092 mmol) are added. The reactions are refluxed for a further 25 h, cooled and poured into methanol. The resulting precipitate is filtered, and extracted (Soxhlet) with acetone (20 h) and iso-hexane (23 h). The products are dried under vacuum to afford purple solids. Regioregularity is calculated by integration of the methylene protons. In each case integrating between 2.95 and 2.65 ppm, and 2.6625 and 2.50 ppm.

Ni (II): Mass = 1.91 g (80%). GPC (C₆H₅Cl, 60ºC, RI) Mₙ 75,500, M_{w} 110,000. Regioregularity is 95.6% by ¹H NMR (see Figure 1 a).
Ni (0) : Mass = 1.83 g (76%). GPC (C₆H₅Cl, 60ºC, RI) Mₙ 141,000, M_{w} 386,000. Regioregularity is 96.2% by ¹H NMR (see Figure 1 b).

### Example 3: Regioregular poly(3-hexyl)selenophene

Butylmagnesium chloride (2.65 ml of a 2M solution in THF, 5.3 mmol) is added to a solution of 2,5-dibromo-3-hexylselenophene (2.12 g, 5.69 mmol) in anhydrous THF (18 ml) at 18-20ºC, under N₂. This mixture is stirred for 25 min at 18-20ºC, then heated at reflux for 1 hour. Reflux is stopped, and 1,2-bis(diphenylphosphino)ethane (46.8 mg, 0.11 mmol) then bis(1,5-cyclooctadiene)nickel (0) (15.6 mg, 0.059 mmol) are added and the resultant mixture is refluxed for 30 h. The reaction mixture is cooled to 40ºC, then poured into warm methanol. The precipitate is filtered and washed with acetone (soxhlet, 15h), methanol (soxhlet, 5h) and iso-hexane (soxhlet 25 h). The solution is dissolve in hot chlorobenzene and precipitated into methanol. The product is filtered, and dried under vacuum, to give the polymer as a purple solid (1.04 g, 85%). GPC (C₆H₅Cl, 60ºC, RI) Mₙ 112,000, M_{w} 314,000. ¹H NMR (CDCl₃, 300 MHz) δ 7.11 (s, 1H), 2.73 (t, 1.9H), 2.55 (br m, 0.1H) 1.69 (m, 2H), 1.5-1.25 (m, 6H), 0.91 (t, 3H) (regioregularity = 96%).

## Claims

1. Process of preparing a regioregular polymer of formula I 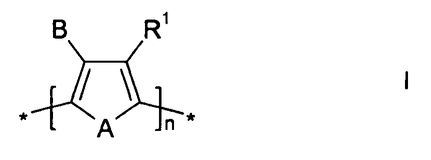 wherein A is S or Se, B is H or F, n is an integer > 1, and R¹ is selected from C₁-C₂₀-alkyl that is optionally substituted with one or more fluorine atoms C₁-C₂₀-alkenyl, C₁-C₂₀-alkinyl, C₁-C₂₀-alkoxy, C₁-C₂₀-thioalkyl, C₁-C₂₀-silyl, C₁-C₂₀-amino or C₁-C₂₀-fluoroalkyl,
by reacting a monomer of formula II 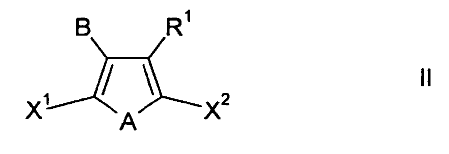 wherein A, B and R¹ are as defined in formula I, and X¹ and X² are independently of each other a suitable leaving group,
with magnesium or reactive zinc or an organomagnesium halide, to form an organomagnesium or organozinc intermediate or a mixture of organomagnesium or organozinc intermediates, and
bringing the resulting intermediate(s) into contact with a catalytic amount of a Ni(0) catalyst and a bidentate ligand, and optionally agitating and/or heating the resulting mixture, to form a polymer.

2. Process according to claim 1, **characterized by**
a1) reacting a compound of formula II with an organomagnesium halide in an organic solvent to generate an organomagnesium intermediate, or alternatively
a2) reacting a compound of formula II with magnesium metal in an organic solvent to generate an organomagnesium intermediate, or alternatively
a3) reacting a compound of formula II with reactive zinc in an organic solvent to generate an organozinc intermediate, or alternatively
a4) generating an organomagnesium intermediate as described in step a1) or a2), and reacting said intermediate with a zinc dihalide to generate an organozinc intermediate,
and
b) adding a catalytic amount of a bidentate organic ligand and a catalytic amount of an organic Ni (0) compound or an organic Ni (0) complex to the intermediate, and optionally agitating and/or heating the resulting mixture, to form a polymer,
and
c) optionally recovering the polymer from the mixture.

3. Process according to one or more of claims 1 to 2, **characterized in that** the organomagnesium halide is selected of formula III
R²-Mg-X¹ III
wherein
R² is aryl or heteroaryl which is optionally substituted by one or more groups L, or straight chain, branched or cyclic alkyl with 1 to 20 C-atoms, which is unsubstituted or mono- or polysubstituted by F, Cl, Br or I, and wherein one or more non-adjacent CH₂ groups are optionally replaced, in each case independently from one another, by -O-, -S-, -NR⁰-, -SiR⁰R⁰⁰-, -CY¹=CY²- or -C≡C- in such a manner that O and/or S atoms are not linked directly to one another,
L is F, Cl, Br, I or alkyl, alkoxy or thioalkyl with 1 to 20 C atoms, wherein one or more H atoms may be substituted by F or Cl,
Y¹ and Y² are independently of each other H, F or Cl,
R⁰ and R⁰⁰ are independently of each other H, alkyl with 1 to 12 C-atoms or aryl,
X¹ is as defined in formula II.

4. Process according to one or more of claims 1 to 3, **characterized in that** the bidentate ligand is a phosphine ligand.

5. Process according to claims 4, **characterized in that** the bidentate ligand is selected from 1,2-bis(diphenylphosphino)ethane (dppe), 1,3-bis(diphenylphosphino)propane (dppp), 1,4-bis(diphenylphosphino)butane (dppb), 1,1'-bis(diphenylphosphino)ferrocene (dppf), 2,2'-bis(diphenylphosphino)-1,1'-binaphthyl (BINAP), and 1,2-bis(dicylohexylphosphino)ethane.

6. Process according to one or more of claims 1 to 5, **characterized in that** the Ni (0) catalyst is Ni(COD)₂ or Ni(CO)₄.

7. Process according to one or more of claims 1 to 6, **characterized in that** it is carried out in a solvent selected from THF, 2-methyltetrahydrofuran, diethyl ether, tetrahydropyran or dioxane.

## Patentansprüche

1. Verfahren zur Herstellung eines regioregulären Polymers der Formel I 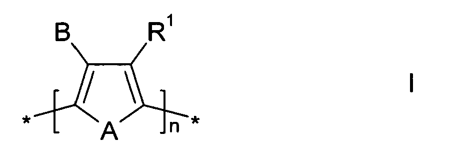 worin A S oder Se ist, B H oder F ist, n eine ganze Zahl > 1 ist und R¹ aus C₁-C₂₀-Alkyl, das gegebenenfalls mit einem oder mehreren Fluoratomen substituiert ist, C₁-C₂₀-Alkenyl, C₁-C₂₀-Alkinyl, C₁-C₂₀-Alkoxy, C₁-C₂₀-Thioalkyl, C₁-C₂₀-Silyl, C₁-C₂₀-Amino oder C₁-C₂₀-Fluoralkyl ausgewählt ist,
durch Umsetzen eines Monomers der Formel II 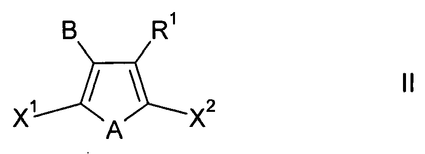 worin A, B und R¹ wie in Formel I definiert sind und X¹ und X² unabhängig voneinander eine geeignete Abgangsgruppe bedeuten,
mit Magnesium oder reaktivem Zink oder einem Organomagnesiumhalogenid zu einem Organomagnesium- oder Organozink-Zwischenprodukt oder einer Mischung aus Organomagnesium- oder Organozink-Zwischenprodukten und
in Kontakt bringen des/der entstandenen Zwischenprodukte(s) mit einer katalytischen Menge eines Ni(0)-Katalysators und eines zweizähnigen Liganden und gegebenenfalls Rühren und/oder Erhitzen der entstandenen Mischung zur Bildung eines Polymers.

2. Verfahren nach Anspruch 1, **dadurch gekennzeichnet, dass** man
a1) eine Verbindung der Formel II mit einem Organomagnesiumhalogenid in einem organischen Lösungsmittel umsetzt, um ein Organomagnesium-Zwischenprodukt zu erzeugen, oder alternativ
a2) eine Verbindung der Formel II mit Magnesiummetall in einem organischen Lösungsmittel umsetzt, um ein Organomagnesium-Zwischenprodukt zu erzeugen, oder alternativ
a3) eine Verbindung der Formel II mit reaktivem Zink in einem organischen Lösungsmittel umsetzt, um ein Organozink-Zwischenprodukt zu erzeugen, oder alternativ
a4) ein Organomagnesium-Zwischenprodukt wie in Schritt a1) oder a2) beschrieben erzeugt und das Zwischenprodukt mit einem Zinkdihalogenid umsetzt, um ein Organozink-Zwischenprodukt zu erzeugen,
und
b) eine katalytische Menge eines zweizähnigen organischen Liganden und eine katalytische Menge einer organischen Ni(0)-Verbindung oder eines organisches Ni(0)-Komplexes zum Zwischenprodukt hinzugibt und die entstandene Mischung zur Bildung eines Polymers gegebenenfalls bewegt und/oder erhitzt,
und
c) gegebenenfalls das Polymer aus der Mischung gewinnt.

3. Verfahren nach einem oder mehreren der Ansprüche 1 bis 2, **dadurch gekennzeichnet, dass** das Organomagnesiumhalogenid aus der Formel III
R²-Mg-X¹ III
ausgewählt ist, worin
R² Aryl oder Heteroaryl, das gegebenenfalls durch eine oder mehrere Gruppen L substituiert ist, oder geradkettiges, verzweigtes oder cyclisches Alkyl mit 1 bis 20 C-Atomen ist, das unsubstituiert oder ein- oder mehrfach durch F, Cl, Br oder I substituiert ist und worin gegebenenfalls eine oder mehrere nicht benachbarte CH₂-Gruppen jeweils unabhängig voneinander so durch -O-, -S-, -NR⁰-, -SiR⁰R⁰⁰-, -CY¹=CY²- oder -C≡Cersetzt sind, dass O- und/oder S-Atome nicht direkt miteinander verknüpft sind,
L F, Cl, Br, I oder Alkyl, Alkoxy oder Thioalkyl mit 1 bis 20 C-Atomen ist, worin ein oder mehrere H-Atome durch F oder Cl substituiert sein können,
Y¹ und Y² unabhängig voneinander H, F oder Cl sind,
R⁰ und R⁰⁰ unabhängig voneinander H, Alkyl mit 1 bis 12 C-Atomen oder Aryl sind,
X¹ wie in Formel II definiert ist.

4. Verfahren nach einem oder mehreren der Ansprüche 1 bis 3, **dadurch gekennzeichnet, dass** es sich bei dem zweizähnigen Liganden um einen Phosphinliganden handelt.

5. Verfahren nach Anspruch 4, **dadurch gekennzeichnet, dass** der zweizähnige Ligand aus 1,2-Bis(diphenylphosphino)ethan (dppe), 1,3-Bis(diphenylphosphino)propan (dppp), 1,4-Bis(diphenylphosphino)butan (dppb), 1,1'-Bis(diphenylphosphino)ferrocen (dppf), 2,2'-Bis(diphenylphosphino)-1,1'-binaphthyl (BINAP) und 1,2-Bis(dicyclohexylphosphino)ethan ausgewählt ist.

6. Verfahren nach einem oder mehreren der Ansprüche 1 bis 5, **dadurch gekennzeichnet, dass** es sich bei dem Ni(0)-Katalysator um Ni(COD)₂ oder Ni(CO)₄ handelt.

7. Verfahren nach einem oder mehreren der Ansprüche 1 bis 6, **dadurch gekennzeichnet, dass** es in einem Lösungsmittel ausgewählt aus THF, 2-Methyltetrahydrofuran, Diethylether, Tetrahydropyran oder Dioxan durchgeführt wird.

## Revendications

1. Procédé de préparation d'un polymère régio-régulier de formule I 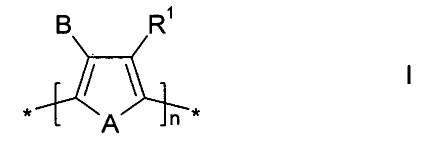 dans laquelle A est S ou Se, B est H ou F, n est un entier > 1, et R¹ est sélectionné parmi C₁-C₂₀-alkyle qui est éventuellement substitué par un ou plusieurs atomes de fluor, C₁-C₂₀-alcényle, C₁-C₂₀-alcynyle, C₁-C₂₀-alcoxy, C₁-C₂₀-thioalkyle, C₁-C₂₀-silyle, C₁-C₂₀-amino ou C₁-C₂₀-fluoralkyle,
par réaction d'un monomère de formule II 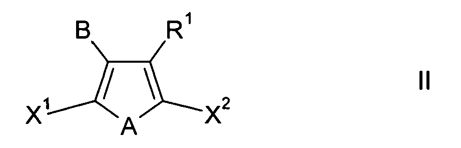 dans laquelle A, B et R¹ sont tels que définis selon la formule I, et X¹ et X² sont, indépendamment l'un de l'autre, un groupement partant convenable,
avec du magnésium ou du zinc réactif ou un halogénure d'organo-magnésium, pour former un intermédiaire d'organomagnésium ou d'organozinc ou un mélange d'intermédiaires d'organomagnésium ou d'organozinc, et
la mise en contact du ou des intermédiaires résultants avec une quantité catalytique d'un catalyseur au Ni(0) et d'un ligand bidenté, et éventuellement l'agitation et/ou le chauffage du mélange résultant, pour former un polymère.

2. Procédé selon la revendication 1, **caractérisé par**
a1) la réaction d'un composé de formule II avec un halogénure d'organomagnésium dans un solvant organique pour générer un intermédiaire d'organomagnésium, ou de manière alternative
a2) la réaction d'un composé de formule II avec du magnésium métallique dans un solvant organique pour générer un intermédiaire d'organomagnésium, ou de manière alternative
a3) la réaction d'un composé de formule II avec du zinc réactif dans un solvant organique pour générer un intermédiaire d'organozinc, ou de manière alternative
a4) la génération d'un intermédiaire d'organomagnésium tel que décrit à l'étape a1) ou a2), et la réaction dudit intermédiaire avec un dihalogénure de zinc pour générer un intermédiaire d'organozinc,
et
b) l'addition d'une quantité catalytique d'un ligand organique bidenté et d'une quantité catalytique d'un composé organique de Ni(0) ou d'un complexe organique de Ni (0) à l'intermédiaire, et éventuellement l'agitation et/ou le chauffage du mélange résultant, pour former un polymère,
et
c) éventuellement la récupération du polymère à partir du mélange.

3. Procédé selon l'une ou plusieurs des revendications 1 à 2, **caractérisé en ce que** l'halogénure d'organomagnésium est sélectionné dans la formule III
R²-Mg-X¹ III
dans laquelle
R² est aryle ou hétéroaryle qui est éventuellement substitué par un ou plusieurs groupements L, ou alkyle à chaîne linéaire, ramifiée ou cyclique ayant 1 à 20 atomes de C, qui est non substitué ou mono- ou poly-substitué par F, CI, Br ou I, et où un ou plusieurs groupements CH₂ non adjacents sont éventuellement remplacés, dans chaque cas indépendamment les uns des autres, par -O-, -S-, -NR⁰-, -SiR⁰R⁰⁰-, -CY¹=CY²- ou -C≡C- de manière telle que les atomes de O et/ou de S ne soient pas directement liés les uns aux autres,
L est F, CI, Br, I ou alkyle, alcoxy ou thioalkyle ayant 1 à 20 atomes de C, où un ou plusieurs atomes de H peuvent être substitués par F ou CI,
Y¹ et Y² sont, indépendamment les uns des autres, H, F ou CI,
R⁰ et R⁰⁰ sont, indépendamment les uns des autres, H, alkyle ayant 1 à 12 atomes de C ou aryle,
X¹ est tel que défini selon la formule II.

4. Procédé selon l'une ou plusieurs des revendications 1 à 3, **caractérisé en ce que** le ligand bidenté est un ligand de phosphine.

5. Procédé selon la revendication 4, **caractérisé en ce que** le ligand bidenté est sélectionné parmi le 1,2-bis(diphénylphosphino)éthane (dppe), le 1,3-bis(diphénylphosphino)propane (dppp), le 1,4-bis-(diphénylphosphino)butane (dppb), le 1,1'-bis(diphénylphosphino)-ferrocène (dppf), le 2,2'-bis(diphénylphosphino)-1,1'-binaphtyle (BINAP), et le 1,2-bis(dicylohexylphosphino)éthane.

6. Procédé selon l'une ou plusieurs des revendications 1 à 5, **caractérisé en ce que** le catalyseur de Ni(0) est Ni(COD)₂ ou Ni(CO)₄.

7. Procédé selon l'une ou plusieurs des revendications 1 à 6, **caractérisé en ce qu'**il est réalisé dans un solvant sélectionné parmi le THF, le 2-méthyltétrahydrofurane, le diéthyléther, le tétrahydropyrane ou le dioxane.
